# FASCICULE DE BREVET EUROPEEN

(11) **EP 3 244 716 B1**
(45) Date de publication et mention de la délivrance du brevet: **30.10.2019**
(21) Numéro de dépôt: 17170171.7
(22) Date de dépôt: 09.05.2017
(51) Int. Cl.: H05K 7/14

(54) **COFFRE ÉLECTRIQUE D'ÉQUIPEMENT FERROVIAIRE ET PROCÉDÉ DE CONNEXION ÉLECTRIQUE INTERNE DANS UN TEL COFFRE**
ELEKTRISCHER KASTEN FÜR EISENBAHNAUSRÜSTUNG, UND INTERNES ELEKTRISCHES ANSCHLUSSVERFAHREN IN DIESEM KASTEN
RAILWAY EQUIPMENT ELECTRICAL CABINET AND INTERNAL ELECTRICAL CONNECTION METHOD IN SUCH A CABINET

(30) Priorité: 10.05.2016 FR 1654178
(43) Date de publication de la demande: 15.11.2017
(73) Titulaire: ALSTOM Transport Technologies, 93400 Saint-Ouen (FR)
(72) Inventeur: DELVAL, Damien, 59600 ASSEVENT (FR)
(74) Mandataire: Lavoix

(56) Documents cités:
- EP-A1- 2 579 438
- JP-A- H0 847 268
- US-A1- 2008 036 340
- US-A1- 2013 016 481
- US-A1- 2013 319 753
- US-A1- 2016 049 777

## Description

La présente invention concerne un coffre électrique d'équipement ferroviaire comprenant :
- au moins deux parties distinctes et étanches à l'eau, et au moins une zone moins étanche à l'eau que les deux parties, voire non étanche à l'eau,
- une charpente comportant une pluralité de tubes reliant les deux parties l'une à l'autre via la zone moins étanche pour assurer une rigidité mécanique du coffre électrique, et
- des câbles de connexion connectant électriquement les deux parties l'une à l'autre.

L'invention concerne également un procédé de connexion électrique de deux parties distinctes d'un tel coffre l'une à l'autre.

Le coffre électrique fait par exemple partie d'une armoire électrique de haute, moyenne ou de basse tension. Le coffre électrique est embarqué, ou non, à bord d'un véhicule ferroviaire.

Pour protéger les câbles de connexion transitant par la zone moins étanche à l'eau, il est connu d'utiliser des presse-étoupes avec bague étanche. On utilise également des gaines dites « passe fil » ou des brides de type Affimes. Il est également connu d'utiliser de la tôlerie intermédiaire entre les deux zones protégées afin de créer une zone spécifique de câblage. Comme la zone de câblage est conçue dans un environnement structurel préexistant, il n'est pas évident de conserver une structure simple. Après l'ajout de crosses de câblage, un capotage important doit être prévu, ainsi qu'un joint d'étanchéité et un système de fixation conséquent de la taille du capot. Sur le capot, des renforts sont ajoutés afin de garantir la bonne tenue du capot et pour assurer une bonne étanchéité.

Selon son abrégé, US-A-2013/319753 décrit une enceinte électrique pouvant abriter un équipement électrique comportant un système de conduits de câbles reconfigurable avec un ou plusieurs volets mobiles pour former des voies alternatives dans l'enceinte pour acheminer les câbles électriques des connexions à l'intérieur de l'enceinte vers des zones désignées à l'extérieur de l'enceinte.

Selon son abrégé, EP-A-2 579 438 décrit une cellule de puissance pour application en eau profonde, comprenant un boîtier, une batterie de condensateurs, un module électronique et des connecteurs d'entrée/sortie. Le boîtier est essentiellement réalisé en un matériau isolant.

Selon son abrégé, JP H08 47268 (A) décrit une partie d'un convertisseur de puissance divisée en une pluralité d'unités de conversion. Les boîtiers des unités de conversion ont des formes parallélépipédiques rectangulaires et les ensembles de bornes avec lesquels les unités sont reliées électriquement à des appareils externes sont prévus sur les faces avant des boîtiers.

Selon son abrégé, US-A-2013/016481 décrit un convertisseur d'énergie électrique comprenant un boîtier de convertisseur de puissance électrique monté sur du matériel roulant, une section de montage d'unité formée dans le boîtier de convertisseur d'énergie électrique et comportant une ouverture d'insertion de refroidisseur et une unité interne montée sur la section de montage de l'unité.

On comprend que les solutions existantes pour connecter électriquement deux zones protégées du coffre via une zone moins protégée sont relativement complexes et/ou coûteuses.

Un but de l'invention est donc de pallier tout ou partie de ces inconvénients, c'est-à-dire en particulier de fournir un coffre électrique moins complexe ou moins coûteux.

A cet effet, l'invention a pour objet un coffre électrique selon la revendication 1.

Selon des modes de réalisation particuliers, le coffre électrique comprend l'une plusieurs des caractéristiques correspondant aux revendications 2 à 9, prise(s) selon toutes les combinaisons techniquement possibles .

L'invention a également pour objet un procédé de connexion électrique selon la revendication 10.

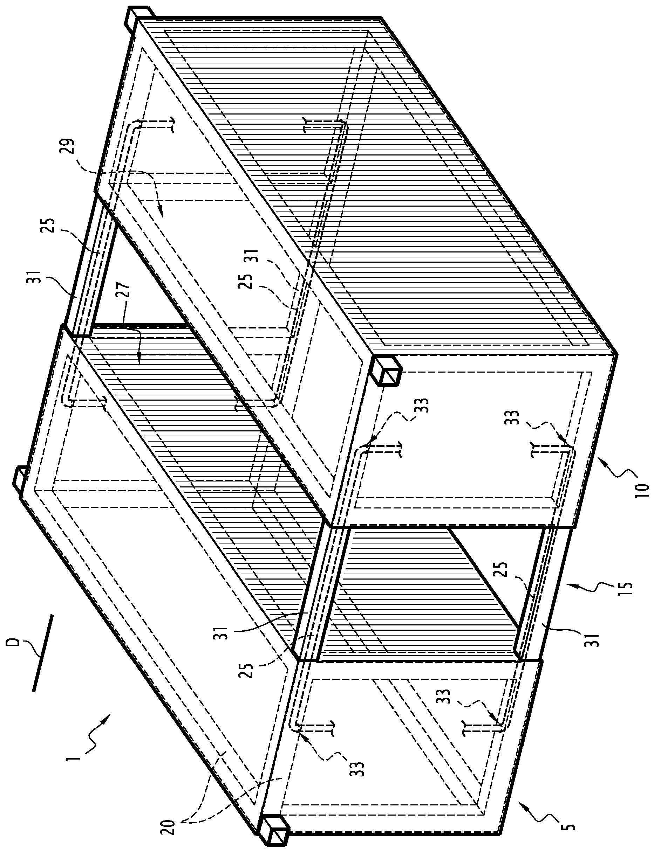

L'invention sera mieux comprise à la lecture de la description qui va suivre, donnée uniquement à titre d'exemple et faite en se référant au dessin annexé, sur lequel la figure est une vue schématique en perspective d'un coffre électrique selon l'invention.

En référence à la figure, on décrit un coffre électrique 1 selon l'invention. Le coffre électrique 1 est adapté pour être, ou faire partie d'une armoire électrique (non représentée). Le coffre électrique 1 est par exemple un convertisseur statique destiné à produire l'électricité nécessaire dans le véhicule ferroviaire en dehors de la propulsion, ou fait partie de la chaîne de traction du véhicule ferroviaire.

En variante, le coffre électrique 1 est ou fait partie d'une station ou d'une sous-station électrique non embarquée, par exemple une sous-station dite « réversible », c'est-à-dire adaptée pour fournir de la puissance électrique à un réseau de distribution, ou pour en recevoir du réseau en cas de freinage d'un véhicule ferroviaire.

Le coffre électrique 1 a par exemple une forme générale sensiblement parallélépipédique. Le coffre électrique 1 comprend deux parties 5, 10 distinctes et étanches à l'eau, une zone 15 non étanche à l'eau et séparant les deux parties l'une de l'autre, une charpente 20 formant une ossature du coffre électrique, et des câbles de connexion 25 connectant électriquement les deux parties l'une à l'autre.

Les deux parties 5, 10 sont avantageusement au moins de classe IP55 du point de vue de l'étanchéité à l'eau selon la norme EN 60529. Elles sont avantageusement également de classe IP55 du point de vue de l'étanchéité au corps étranger.

Les parties 5, 10 sont par exemple de forme extérieure analogue l'une à l'autre, et avantageusement de forme générale parallélépipédique. Les parties 5, 10 sont par exemple disposées parallèlement l'une à l'autre.

Les parties 5, 10 sont par exemple constituées extérieurement par des faces fixées sur des tubes de la charpente 20, lesdits tubes se situant à l'intérieur des deux parties et étant représentés en transparence sur la figure.

Selon une variante non représentée, les parties 5, 10 sont fixées sur la charpente 20, lesdits tubes restant extérieurs aux deux parties.

Les parties 5, 10 comprennent respectivement des faces de connexion 27, 29.

Les faces de connexion 27, 29 sont par exemple sensiblement parallèles l'une à l'autre et sont situées de part et d'autre de la zone 15 selon une direction de connexion D.

La zone 15 s'étend entre les parties 5, 10 dans la direction de connexion D, avantageusement depuis la face de connexion 27 de la partie 5 jusqu'à la face de connexion 29 de la partie 10. Dans l'exemple, la zone 15 est simplement traversée par des tubes de la charpente 20 et par les câbles de connexion 25.

Selon une variante non représentée, la zone 15 est partiellement étanche à l'eau, mais moins que ne le sont les parties 5, 10.

La zone 15 est par exemple au plus de classe IP20, selon la même norme, du point de vue de l'étanchéité au corps étranger.

La charpente 20 constitue une structure porteuse du coffre électrique 1. Dans l'exemple représenté, la charpente 20 comporte des tubes s'étendant selon les arêtes du coffre électrique 1, et avantageusement des tubes s'étendant selon les arêtes des parties 5, 10.

La charpente 20 comporte en particulier quatre tubes 31 traversant la zone 15 selon la direction de connexion D.

Les tubes 31 se prolongent au-delà des faces de connexion 27, 29 et ne doivent pas être confondus avec de simples tubes reliant les parties 5, 10. Les tubes 31 se prolongent avantageusement jusqu'aux extrémités du coffre électrique 1 selon la direction de connexion D. Les tubes 31 sont par exemple fixés sur des tubes transversaux de la charpente 20 par rapport à la direction de connexion D.

Dans l'exemple représenté, chacun des tubes 31 est à section rectangulaire, avantageusement carrée. Chacun des tubes 31 abrite par exemple l'un des câbles de connexion 25 dans la zone 15.

Chacun des tubes 31 comprend par exemple deux orifices 33 permettant au câble de connexion 25 situé dans ledit tube de déboucher à l'intérieur des parties 5, 10.

Selon des variantes non représentées, tous les tubes 31 n'abritent pas l'un des câbles de connexion 25, ou certains des tubes 31 abritent plusieurs des câbles de connexion 25.

Selon d'autres variantes encore (non représentées), les câbles de connexion 25 empruntent des tubes de la charpente 20 pour traverser la zone 15, lesdits tubes ne s'étendant pas selon des arêtes du coffre électrique 1. Ces variantes sont notamment adaptées à des coffres électriques de grandes dimensions, possédant une charpente plus complexe que celle représentée.

Les tubes abritant les câbles de connexion 25 sont au moins aussi étanches que les parties 5, 10, au moins dans la zone 15, de manière à constituer une protection des câbles de connexion 25 dans la zone 15, les câbles de connexion étant par ailleurs protégés lorsqu'ils se trouvent dans les parties 5, 10.

Un procédé de connexion électrique selon l'invention va maintenant être décrit brièvement, car il se déduit de la structure du coffre électrique 1 décrit précédemment.

Pour connecter électriquement les deux parties 5, 10, on fournit les deux parties et la charpente 20, et on connecte électriquement les deux parties l'une à l'autre par les câbles de connexion 25, ceux-ci étant disposés à l'intérieur des tubes 31 de la charpente 20.

Grâce aux caractéristiques décrites ci-dessus, les câbles de connexion 25 sont protégés lors de leur traversée de la zone 15, au moins autant qu'ils le sont dans les parties 5, 10. La protection est assurée par les tubes 31 de la charpente 20. Pour ces câbles de connexion 25, aucun équipement de protection supplémentaire n'est nécessaire. Ainsi, les équipements de protection mentionnés dans le préambule de la présente demande sont éliminés, ou bien leur nombre est réduit. En conséquence, le coffre électrique 1 est plus simple à fabriquer et moins coûteux.

Dans ce qui précède, par la « EN 60529 », on se réfère par exemple à la norme CEI 60529 Edition 2.2 2013-08, d'août 2013. Cette norme définit des degrés de protection par des codes « IP » comportant deux chiffres, bien connus de l'homme du métier. Ces codes et leur définition ont très peu évolué depuis la première version éditée en 1989.

Le premier chiffre de la catégorie IP définit la protection contre les corps étrangers, et le second la protection contre la pénétration de l'eau.

Selon cette norme, un matériel de catégorie IP55 est tel qu'il est protégé contre la poussière. La pénétration de la poussière n'est pas totalement évitée, mais la poussière ne pénètre pas en quantité suffisante pour nuire au bon fonctionnement du matériel et à la sécurité.

Du point de vue de l'étanchéité à l'eau, la catégorie IP55 est telle que le matériel est protégé contre les jets d'eau. L'eau projetée en jets de toutes les directions sur l'enveloppe du matériel ne doit pas avoir d'effets nuisibles.

Toujours selon cette norme, un matériel de catégorie IP20 est tel qu'il est protégé contre les corps solides étrangers de diamètre supérieur ou égal à 12,5 mm. Un objet calibré sphérique de diamètre 12,5 mm ne doit pas pénétrer complètement.

Du point de vue de l'étanchéité à l'eau, la catégorie IP20 est telle que le matériel n'est pas protégé contre la pénétration de l'eau.

## Revendications

1. Coffre électrique (1) d'équipement ferroviaire, le coffre électrique (1) comprenant :
- au moins deux parties (5, 10) distinctes et étanches à l'eau, et au moins une zone (15) moins étanche à l'eau que les deux parties (5, 10), voire non étanche à l'eau, et séparant les deux parties (5, 10) l'une de l'autre,
- une charpente (20) formant une ossature du coffre électrique (1) et constituant une structure porteuse du coffre électrique (1), et
- des câbles de connexion (25) connectant électriquement les deux parties (5, 10) l'une à l'autre,
**caractérisé en ce que** :
- la charpente comporte une pluralité de tubes (31), les tubes (31) reliant les deux parties (5, 10) l'une à l'autre via la zone (15) moins étanche pour assurer une rigidité mécanique du coffre électrique (1), et
- les câbles de connexion (25) sont disposés à l'intérieur de tubes (31) de ladite pluralité, les tubes (31) ayant des câbles de connexion (25) étant au moins aussi étanches à l'eau que les deux parties (5, 10), au moins dans ladite zone (15) moins étanche.

2. Coffre électrique (1) selon la revendication 1, dans lequel chacune des deux parties (5, 10) est au moins de classe IP55 du point de vue de l'étanchéité à l'eau.

3. Coffre électrique (1) selon la revendication 2, dans lequel chacune des deux parties (5, 10) est au moins de classe IP55 du point de vue de l'étanchéité aux corps étrangers.

4. Coffre électrique (1) selon l'une quelconque des revendications 1 à 3, dans lequel la zone (15) moins étanche est au plus de classe IP20 du point de vue de l'étanchéité au corps étrangers.

5. Coffre électrique (1) selon l'une quelconque des revendications 1 à 4, dans lequel tous les tubes (31) de ladite pluralité comprennent au moins un desdits câbles de connexion (25).

6. Coffre électrique (1) selon l'une quelconque des revendications 1 à 5, dans lequel chacune des deux parties (5, 10) comprend une face de connexion (27, 29), la face de connexion (27, 29) de l'une des deux parties (5, 10) étant située en vis-à-vis de la face de connexion (27, 29) de l'autre des deux parties (5, 10), les faces de connexion (27, 29) étant sensiblement parallèles l'une à l'autre.

7. Coffre électrique (1) selon la revendication 6, dans lequel les faces de connexion (27, 29) sont sensiblement planes.

8. Coffre électrique (1) selon la revendication 7, dans lequel les tubes (31) ayant des câbles de connexion (25) sont sensiblement perpendiculaires aux faces de connexion (27, 29).

9. Coffre électrique (1) selon l'une quelconque des revendications 1 à 8, dans lequel le coffre électrique (1) possède une forme générale parallélépipédique, et dans lequel les tubes (31) ayant des câbles de connexion (25) forment par exemple une arête du coffre électrique (1).

10. Procédé de connexion électrique d'au moins deux parties (5, 10) distinctes d'un coffre électrique (1) d'équipement ferroviaire, comprenant les étapes suivantes :
- fourniture des deux parties (5, 10), les deux parties (5, 10) étant étanches à l'eau, et fourniture d'au moins une zone (15) moins étanche à l'eau que les deux parties (5, 10), voire non étanche à l'eau, et séparant les deux parties (5, 10) l'une de l'autre,
- fourniture d'une charpente (20) comportant une pluralité de tubes (31), les tubes (31) reliant les deux parties (5, 10) l'une à l'autre via la zone (15) moins étanche pour assurer une rigidité mécanique du coffre électrique (1), la charpente (20) formant une ossature du coffre électrique (1) et constituant une structure porteuse du coffre électrique (1), et
- connexion électrique des deux parties (5, 10) l'une à l'autre par des câbles de connexion (25), les câbles de connexion (25) étant disposés à l'intérieur de tubes (31) de ladite pluralité, les tubes (31) ayant des câbles de connexion (25) étant au moins aussi étanches à l'eau que les deux parties (5, 10), au moins dans ladite zone (15) moins étanche.

## Patentansprüche

1. Elektrokasten (1) einer bahntechnischen Ausrüstung, wobei der Elektrokasten (1) umfasst:
- mindestens zwei unterschiedliche und wasserdichte Teile (5, 10) und mindestens eine weniger wasserdichte Zone (15) als die zwei Teile (5, 10), d.h. nicht wasserdichte Zone, die die zwei Teile (5, 10) voneinander trennt,
- ein Rahmenwerk (20), das ein Gerüst des Elektrokastens (1) bildet und eine Tragkonstruktion des Elektrokastens (1) darstellt, und
- Verbindungskabel (25) die elektrisch die zwei Teile (5, 10) miteinander verbinden,
**dadurch gekennzeichnet, dass**:
- das Rahmenwerk eine Mehrzahl von Rohren (31) aufweist, wobei die Rohre (31) die zwei Teile (5, 10) über die weniger wasserdichte Zone (15) miteinander verbinden, um eine mechanische Steifigkeit des Elektrokastens (1) sicherzustellen, und
- die Verbindungskabel (25) im Inneren von Rohren (31) der genannten Mehrzahl angeordnet sind, wobei die die Verbindungskabel (25) aufweisenden Rohre (31) mindestens in der weniger wasserdichten Zone (15) mindestens genauso wasserdicht sind wie die zwei Teile (5, 10).

2. Elektrokasten (1) nach Anspruch 1, bei dem jedes der zwei Teile (5, 10) hinsichtlich der Wasserdichtigkeit mindestens von der Klasse IP55 ist.

3. Elektrokasten (1) nach Anspruch 2, bei dem jedes der zwei Teile (5, 10) hinsichtlich der Dichtigkeit gegen Fremdkörper mindestens von der Klasse IP55 ist.

4. Elektrokasten (1) nach einem beliebigen der Ansprüche 1 bis 3, bei dem die weniger dichte Zone (15) hinsichtlich der Dichtigkeit gegen Fremdkörper höchstens von der Klasse IP20 ist.

5. Elektrokasten (1) nach einem beliebigen der Ansprüche 1 bis 4, bei dem alle Rohre (31) der genannten Mehrzahl mindestens eines der Verbindungskabel (25) umfassen.

6. Elektrokasten (1) nach einem beliebigen der Ansprüche 1 bis 5, bei dem jedes der zwei Teile (5, 10) eine Verbindungsfläche (27, 29) umfasst, wobei die Verbindungsfläche (27, 29) eines der zwei Teile (5, 10) gegenüber der Verbindungsfläche (27, 29) des anderen der zwei Teile (5, 10) angeordnet ist, wobei die Verbindungsflächen (27, 29) im Wesentlichen parallel zueinander sind.

7. Elektrokasten (1) nach Anspruch 6, bei dem die Verbindungsflächen (27, 29) im Wesentlichen eben sind.

8. Elektrokasten (1) nach Anspruch 7, bei dem die die Verbindungskabel (25) aufweisenden Rohre (31) im Wesentlichen senkrecht zu den Verbindungsflächen (27, 29) sind.

9. Elektrokasten (1) nach einem beliebigen der Ansprüche 1 bis 8, bei dem der Elektrokasten (1) allgemein quaderförmig ist und bei dem die die Verbindungskabel (25) aufweisenden Rohre (31) beispielsweise eine Kante des Elektrokastens (1) bilden.

10. Verfahren zur elektrischen Verbindung von mindestens zwei unterschiedlichen Teilen (5, 10) eines Elektrokastens (1) einer bahntechnischen Ausrüstung, die folgenden Schritte umfassend:
- Bereitstellen der zwei Teile (5, 10), wobei die zwei Teile (5, 10) wasserdicht sind, und Bereitstellen mindestens einer weniger wasserdichten Zone (15) als die zwei Teile (5, 10), d.h. nicht wasserdichten Zone, die die zwei Teile (5, 10) voneinander trennt,
- Bereitstellen eines Rahmenwerks (20), das eine Mehrzahl von Rohren (31) aufweist, wobei die Rohre (31) die zwei Teile (5, 10) über die weniger wasserdichte Zone (15) miteinander verbinden, um eine mechanische Steifigkeit des Elektrokastens (1) sicherzustellen, wobei das Rahmenwerk (20) ein Gerüst des Elektrokastens (1) bildet und eine Tragkonstruktion des Elektrokastens (1) darstellt, und
- elektrisches Verbinden der zwei Teile (5, 10) miteinander durch Verbindungskabel (25), wobei die Verbindungskabel (25) im Inneren der Rohre (31) der genannten Mehrzahl angeordnet sind, wobei die die Verbindungskabel (25) aufweisenden Rohre (31) mindestens in der weniger wasserdichten Zone (15) mindestens genauso wasserdicht sind wie die zwei Teile (5, 10).

## Claims

1. Electrical cabinet (1) for railway equipment, the electrical cabinet (1) comprising:
- at least two separate water-tight parts (5, 10) and at least one zone (15) which is less water-tight than the two parts (5, 10) or even not water-tight and which separates the two parts (5, 10) from one another,
- a frame (20) forming a skeleton of the electrical cabinet (1) and constituting a bearing structure of the electrical cabinet (1), and
- connection cables (25) which electrically connect the two parts (5, 10) to one another,
**characterised in that**:
- the frame comprises a plurality of tubes (31), the tubes (31) connecting the two parts (5, 10) to one another *via* the less tight zone (15) in order to ensure mechanical rigidity of the electrical cabinet (1), and
- the connection cables (25) are arranged inside tubes (31) of said plurality, the tubes (31) having connection cables (25) being at least as water-tight as the two parts (5, 10), at least in said less tight zone (15).

2. Electrical cabinet (1) according to claim 1, wherein each of the two parts (5, 10) is at least of class IP55 from the point of view of water tightness.

3. Electrical cabinet (1) according to claim 2, wherein each of the two parts (5, 10) is at least of class IP55 from the point of view of tightness to foreign bodies.

4. Electrical cabinet (1) according to any one of claims 1 to 3, wherein the less water-tight zone (15) is at most of class IP20 from the point of view of tightness to foreign bodies.

5. Electrical cabinet (1) according to any one of claims 1 to 4, wherein all the tubes (31) of said plurality comprise at least one of said connection cables (25).

6. Electrical cabinet (1) according to any one of claims 1 to 5, wherein each of the two parts (5, 10) comprises a connection face (27, 29), the connection face (27, 29) of one of the two parts (5, 10) being situated opposite the connection face (27, 29) of the other of the two parts (5, 10), the connection faces (27, 29) being substantially parallel to one another.

7. Electrical cabinet (1) according to claim 6, wherein the connection faces (27, 29) are substantially planar.

8. Electrical cabinet (1) according to claim 7, wherein the tubes (31) having connection cables (25) are substantially perpendicular to the connection faces (27, 29).

9. Electrical cabinet (1) according to any one of claims 1 to 8, wherein the electrical cabinet (1) is generally parallelepipedal in shape, and wherein the tubes (31) having connection cables (25) form, for example, an edge of the electrical cabinet (1).

10. Method for electrically connecting at least two separate parts (5, 10) of an electrical cabinet (1) for railway equipment, comprising the following steps:
- providing the two parts (5, 10), the two parts (5, 10) being water-tight, and providing at least one zone (15) which is less water-tight than the two parts (5, 10) or even not water-tight and which separates the two parts (5, 10) from one another,
- providing a frame (20) comprising a plurality of tubes (31), the tubes (31) connecting the two parts (5, 10) to one another *via* the less tight zone (15) in order to ensure mechanical rigidity of the electrical cabinet (1), the frame (20) forming a skeleton of the electrical cabinet (1) and constituting a bearing structure of the electrical cabinet (1), and
- electrically connecting the two parts (5, 10) to one another by connection cables (25), the connection cables (25) being arranged inside tubes (31) of said plurality, the tubes (31) having connection cables (25) being at least as water-tight as the two parts (5, 10), at least in said less tight zone (15).
